# EUROPEAN PATENT APPLICATION

(11) **EP 2 899 550 A1**
(43) Date of publication of application: **29.07.2015**
(21) Application number: 13838634.7
(22) Date of filing: 20.09.2013
(51) Int. Cl.: G01R 15/14

(54) **SHUNT RESISTANCE-TYPE CURRENT SENSOR**

(30) Priority: 21.09.2012 JP 2012208093
(71) Applicant: Yazaki Corporation, Minato-ku Tokyo 108-8333 (JP)
(72) Inventor: SATO, Takashi, Susono-shi, Shizuoka 410-1194 (JP)
(74) Representative: Grünecker Patent- und Rechtsanwälte PartG mbB
(86) International application number: PCT/JP2013/075533
(87) International publication number: WO 2014/046246

(57) **Abstract**

In a shunt resistance-type current sensor (1), a pair of voltage detection lands (21a) and a voltage detection IC (30) are disposed away from one another to the extent that it is possible to suppress the thermal influence on the pair of voltage detection lands (21 a) caused by the heat generated by means of the voltage detection IC (30).

## Description

### Technical Field

The present invention relates to a shunt resistance type current sensor.

### Background Art

Conventionally, a shunt resistance type current sensor is proposed that flows a current to be measured through a shunt resistor which resistance value is known and detects a voltage drop generated across the shunt resistor to thereby detect a value of the current to be measured such as a pulse current or a large AC current. For example, vehicles such as automobiles sometimes use metal pieces called bus bars for power distribution. In this case, a part of the bus bar corresponding to a current path is utilized as a shunt resistor. A circuit board is disposed on the bus bar. On the circuit board, a voltage detector for detecting a voltage value is mounted in order to detect a value of the current to be measured flowing through the bus bar. The bus bar is electrically connected to the circuit board via connection terminals.

A patent literature 1 discloses a current sensor which includes a bus bar interposed in a current path as a measurement subject and a flexible wiring board in which a current measurement circuit is incorporated. In this current sensor, the flexible wiring board is disposed so as to be overlapped with the bus bar. The flexible wiring board and the bus bar are electrically and mechanically connected by means of soldering etc. via a pair of connection terminals.

A patent literature 2 discloses a current sensor which includes a bus bar interposed in a current path as a measurement subject and a circuit board in which a current measurement circuit is incorporated. In the bus bar, a pair of pin-like connection terminals of a linear shape are disposed so as to be erected therefrom. The bus bar and the circuit board are electrically and mechanically connected via the pair of pin-like connection terminals.

According to a method disclosed in a patent literature 3, a bus bar connected to the anode terminal of a battery also acts as a shunt resistor for detecting the value of the battery current. In this respect, the bus bar and the circuit board are electrically connected via a pair of pole-like connection terminals for detecting a voltage drop across the shunt resistor.

### Citation List

### Patent Literature

Patent Literature 1: JP-A-2005-188972
Patent Literature 2: JP-A-2005-188973
Patent Literature 3: JP-A-2009-40314

### Summary of Invention

### Technical Problem

According to the methods disclosed in the patent literatures 1 to 3, a length of the voltage detection section of the bus bar, that is, a length between the pair of the connection terminals positioned at the bus bar is substantially same as a length between the pair of the connection terminals positioned at the circuit board. Thus, the length between the pair of the connection terminals positioned at the circuit board becomes large. An element for detecting the voltage drop is mounted on the circuit board. Temperature distribution, representing that temperature differs according to a position, arises on the circuit board due to heat generated by the element. Although the pair of the connection terminals are respectively connected to circuit patterns formed on the circuit board via voltage detection lands, temperature difference arises between the pair of voltage detection lands due to the temperature distribution. Thus, a thermal electromotive force is generated between copper as material of a wiring pattern on the circuit board and copper alloy of the bus bar. Accordingly, the voltage drop generated across the shunt resistor may not be detected accurately due to the thermal electromotive force.

The invention has been made in view of the aforesaid problem, and an object of the invention is to suppress generation of a thermal electromotive force to thereby accurately detect voltage drop generated across a shunt resistor.

### Means for Solving the Problems

In order to solve the aforesaid problem, a shunt resistance type current sensor according to a mode of the invention includes:
a bus bar having a plate shape;
a circuit board that is disposed above the bus bar;
a pair of connection terminals that electrically connect between the circuit board and the bus bar; and
a voltage detector that is mounted on the circuit board, and detects a value of voltage applied to the circuit board via the pair of connection terminals in order to detect a value of current to be measured flowing through the bus bar,
wherein the circuit board includes a pair of circuit patterns and a pair of voltage detection lands for electrically connecting between the pair of circuit patterns and the connection terminals, one end of each of the circuit patterns being connected to the voltage detector and the other end of the each of the circuit patterns being connected to corresponding one of the voltage detection lands, and
wherein the pair of voltage detection lands and the voltage detector are disposed separately to each other to a degree that thermal influence on the pair of voltage detection lands due to heat generated by the voltage detector can be suppressed.

In the shunt resistance type current sensor according to the invention, preferably, the pair of voltage detection lands are respectively disposed at positions close to each other to a degree that temperatures of the lands are regarded to be substantially same value, on the circuit board which temperature distribution becomes non-uniform due to the heat generated by the voltage detector.

In the shunt resistance type current sensor according to the invention, preferably, a distance between the pair of voltage detection lands is shorter than a distance between the pair of voltage detection lands and the voltage detector.

In the shunt resistance type current sensor according to the invention, preferably, each of the pair of connection terminals is configured by a narrow plate member which thickness is smaller than a thickness of the bus bar, and

Wherein the connection terminals, that extend on a plane where the bus bar is formed, are raised toward the circuit board and penetrate the circuit board at positions where the voltage detection lands are provided, respectively.

In the shunt resistance type current sensor according to the invention, desirably, each of the pair of connection terminals is composed of same material as the bus bar.

### Advantageous Effects of Invention

According to the invention, the thermal influence on the pair of voltage detection lands due to heat generated by the voltage detector can be suppressed. Further, a situation that temperature difference arises between the pair of voltage detection lands can be suppressed. As a consequence, since a thermal electromotive force generated between a wiring pattern on the circuit board and the bus bar can be suppressed, a voltage drop generated across the shunt resistor can be detected accurately.

### Brief Description of Drawings

[Fig. 1] Fig. 1 is a top view schematically showing a shunt resistance type current sensor according to an embodiment.
[Fig. 2] Fig. 2 is a side view schematically showing the shunt resistance type current sensor shown in Fig. 1.
[Fig. 3] Fig. 3 is a top view schematically showing the main part of the shunt resistance type current sensor, in particular as to a bus bar.
[Fig. 4] Fig 4 is an explanatory diagram schematically showing the using state of the shunt resistance type current sensor.
[Fig. 5] Fig 5 is a top view schematically showing a shunt resistance type current sensor as a modified example.
[Fig. 6] Fig. 6 is a top view schematically showing a shunt resistance type current sensor as another modified example.

### Description of Embodiments

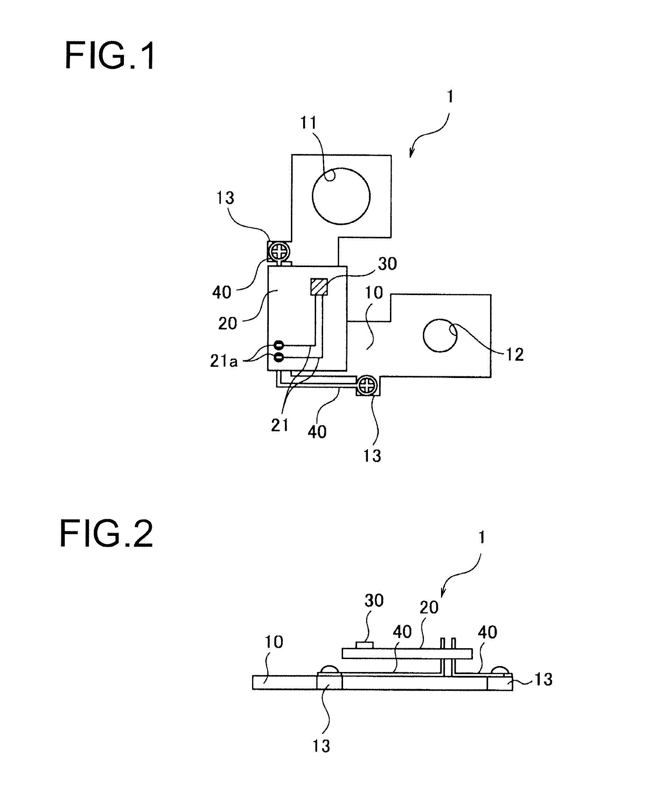

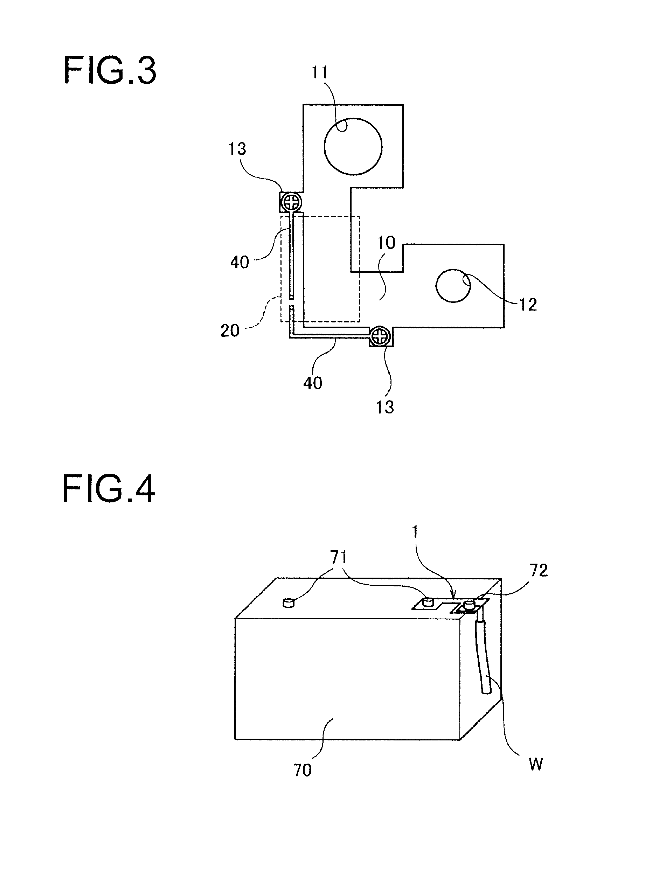

Fig. 1 is a top view schematically showing a shunt resistance type current sensor 1 according to an embodiment. The shunt resistance type current sensor 1 according to the embodiment is used as a battery terminal and mainly configured by a bus bar 10 and a circuit board 20. Fig. 2 is a side view schematically showing the shunt resistance type current sensor 1 shown in Fig. 1. Fig. 3 is a top view schematically showing the main part of the shunt resistance type current sensor 1, in particular as to the bus bar 10, and also is an explanatory diagram showing the shunt resistance type current sensor 1 except for the circuit board 20.

The bus bar 10 is a conductive member of an almost flat shape and composed of copper manganese alloy or copper nickel alloy, for example. The bus bar 10 detects a voltage drop caused in the bus bar 10 via another part (portion between bus bar voltage detection parts 13 described later) separately from the main body of the bus bar to thereby detect a current flowing through the bus bar. This anther part functions as a shunt resistor. The bus bar 10 is formed in a desired shape by press forming flat-shaped steel material.

In this embodiment, the bus bar 10 is formed in an almost L-shape, for example, and through holes 11, 12 are formed at the both tip ends thereof, respectively. The one through hole 11 acts as a hole for a battery post, whilst the other through hole 12 acts as a hole for a wire-harness fixing screw.

Further, the bus bar 10 is provided with a pair of the bus bar voltage detection parts 13. The pair of bus bar voltage detection parts 13 constitute the both ends of the shunt resistor. Each of the bus bar voltage detection parts 13 is integrally formed with the bus bar 10 and configured in a shape partially protruding outward from a peripheral portion of the bus bar 10. Incidentally, the shape of the bus bar voltage detection part 13 is not limited to such the shape protruding outward from the peripheral portion of the bus bar 10.

The circuit board 20 is disposed above the bus bar 10 so as to be spaced with a predetermined distance therebetween in an opposed manner. A voltage detection IC 30 is mounted on the circuit board 20 and connected to a pair of circuit patterns 21 formed on the circuit board 20. In order to detect the value of a current to be measured flowing through the bus bar 10, the voltage detection IC 30 (voltage detector) detects the value of a voltage applied to the circuit board 20 via a pair of connection terminals 40 described later and the bus bar voltage detection parts 13, that is, the value of a voltage applied to the shunt resistor of the bus bar 10. Thus, the voltage detection IC 30 detects a voltage drop generated across the shunt resistor of the bus bar 10 and detects the value of the current to be measured flowing through the bus bar 10.

The pair of circuit patterns 21 formed on the circuit board 20 will be explained. Each of the circuit patterns 21 is connected at its one end to the voltage detection IC 30 and connected at its the other end to corresponding one of voltage detection lands 21a. The other ends of the circuit patterns 21 are electrically connected to the connection terminals 40 via the voltage detection lands 21a, respectively. The connection between the connection terminals 40 and the voltage detection lands 21a is performed by means of soldering, for example, but may be performed by other method.

The voltage detection land 21a provided at the one of the circuit patterns 21 is set so as to locate near the voltage detection land 21 a provided at the other of the circuit patterns 21. That is, the pair of voltage detection lands 21a are disposed closely. Since the pair of voltage detection lands 21a are disposed in this positional relation, the two voltage detection lands 21a can be respectively disposed at positions close to each other to such a degree that the temperatures of these lands can be regarded to be substantially same value, on the circuit board 20 which temperature distribution becomes non-uniform due to the heat generated by the voltage detection IC 30.

On the other hand, the pair of voltage detection lands 21 a are disposed separately from the voltage detection IC 30 on the circuit board 20 in a manner that the distance between the pair of voltage detection lands 21 a and the voltage detection IC 30 is large. According to this arrangement, thermal influence on the voltage detection lands 21 a due to the heat generated by the voltage detection IC 30 can be suppressed.

Further, the shunt resistance type current sensor 1 includes the pair of connection terminals 40 for electrically and mechanically connecting between the bus bar 10 and the circuit board 20. Each of the connection terminals 40 is configured by a narrow thin plate member. The plate thickness of the connection terminal 40 is preferably set to be smaller than that of the bus bar 10. Each of the connection terminals 40 can be composed of copper alloy generally used as spring material but is preferably composed of the same material as the bus bar 10, for example, copper manganese alloy or copper nickel alloy.

Each of the connection terminals 40 is connected at is one end to the corresponding bus bar voltage detection part 13 of the bus bar 10 and extends, along the periphery of the bus bar 10, on a plane forming the bus bar 10. Further, as shown in Fig. 2, each of the connection terminals 40 is bent by 90 degrees at a portion beneath the circuit board 20 so as to be raised upward toward the circuit board 20. After being raised, each of the connection terminals 40 is extended straightly, and then the other end of each of the connection terminals 40 penetrates the circuit board 20 from the lower surface to the upper surface thereof at a portion where the corresponding voltage detection land 21 a is provided. Then, the other end of each of the connection terminals 40 is connected to the corresponding voltage detection land 21a. Although, for example, a screwing is used as a connecting method between the connection terminals 40 and the bus bar voltage detection part 13, other methods such as a soldering may be used therefor. Since each of the connection terminals 40 is configured by the narrow thin plate member and bent by 90 degrees, the difference of thermal expansion between the bus bar 10 and the circuit board 20 can be absorbed. Further, since each of the connection terminals 40 is configured by the thin plate member which can be deformed easily, even when an external force acts on the circuit board 20, such a situation can be suppressed that a stress is generated at the connection portion between the connection terminals and the circuit board 20.

Fig.4 is an explanatory diagram schematically showing the using state of the shunt resistance type current sensor 1 according to the embodiment. The bus bar 10 of the shunt resistance type current sensor 1 according to the embodiment is used as a battery terminal. For example, the through hole 11 of the bus bar 10 is connected to a battery post 71 on the anode side of the battery 70, and the other through hole 12 is connected to a wire harness W via a wire-harness fixing screw 72. In this case, in the shunt resistance type current sensor 1, the circuit board 20 etc. is housed within a not-shown exterior case.

In the shunt resistance type current sensor 1 according to such the embodiment, the circuit board 20 includes the pair of circuit patterns 21 and the pair of voltage detection lands 21a for electrically connecting between the pair of circuit patterns 21 and the connection terminals 40, respectively. Each of the pair of circuit patterns 21 is connected at its one end to the voltage detection IC 30, whilst each of the pair of circuit patterns 21 is connected at its the other end to the corresponding voltage detection land 21 a. In this configuration, the pair of voltage detection lands 21 a are respectively disposed at the positions close to each other to such a degree that the temperatures of these lands can be regarded to be substantially same temperature, on the circuit board 20 which temperature distribution becomes non-uniform due to the heat generated by the voltage detection IC 30. Further, the pair of voltage detection lands 21a are disposed separately from the voltage detection IC 30 to a degree that the thermal influence on the voltage detection lands 21 a due to the heat generated by the voltage detection IC 30 can be suppressed.

According to such the configuration, since the pair of voltage detection lands 21 a are disposed separately from the voltage detection IC 30, the thermal influence on the voltage detection lands 21a due to the heat generated by the voltage detection IC 30 can be suppressed. Further, since the pair of voltage detection lands 21 a are disposed close to each other, the pair of voltage detection lands 21 a can be respectively disposed at such the positions that the temperatures of these lands are regarded to be substantially same value, on the circuit board 20 which temperature distribution becomes non-uniform due to the heat generated by the voltage detection IC 30. Thus, such a situation can be suppressed that the temperature difference arises between the pair of voltage detection lands 21 a. As a consequence, since the thermal electromotive force generated between the circuit pattern 21 on the circuit board 20 and the bus bar 10 can be suppressed, the voltage drop generated across the shunt resistor can be detected accurately.

According to another aspect of the embodiment, the distance between the pair of voltage detection lands 21 a is set so as to be shorter than the distance between the pair of voltage detection lands 21 a and the voltage detection IC 30. Thus, such the situation that the temperature difference arises between the pair of voltage detection lands 21a can be suppressed while suppressing the thermal influence on the voltage detection lands 21 a due to the heat generated by the voltage detection IC 30.

Further, in this embodiment, each of the connection terminals 40 is configured by the narrow plate member which thickness is smaller than the thickness of the bus bar 10. The connection terminals 40, that extend on the plane forming the bus bar 10, are raised beneath the circuit board 20 and penetrate the circuit board 20 at the positions where the voltage detection lands 21a are provided, respectively.

According to such the configuration, the difference of thermal expansion between the bus bar 10 and the circuit board 20 can be absorbed. Further, since each of the connection terminals 40 is configured by the thin plate member which can be deformed easily, even when an external force acts on the circuit board 20, such the situation can be suppressed that a stress is generated at the connection portion between the connection terminals and the circuit board 20.

Further, in this embodiment, each of the connection terminals 40 is composed of same material as the bus bar 10.

According to such the configuration, the thermal electromotive force is hardly generated even when the temperature difference arises between the bus bar voltage detection parts 13 of the bus bar 10.

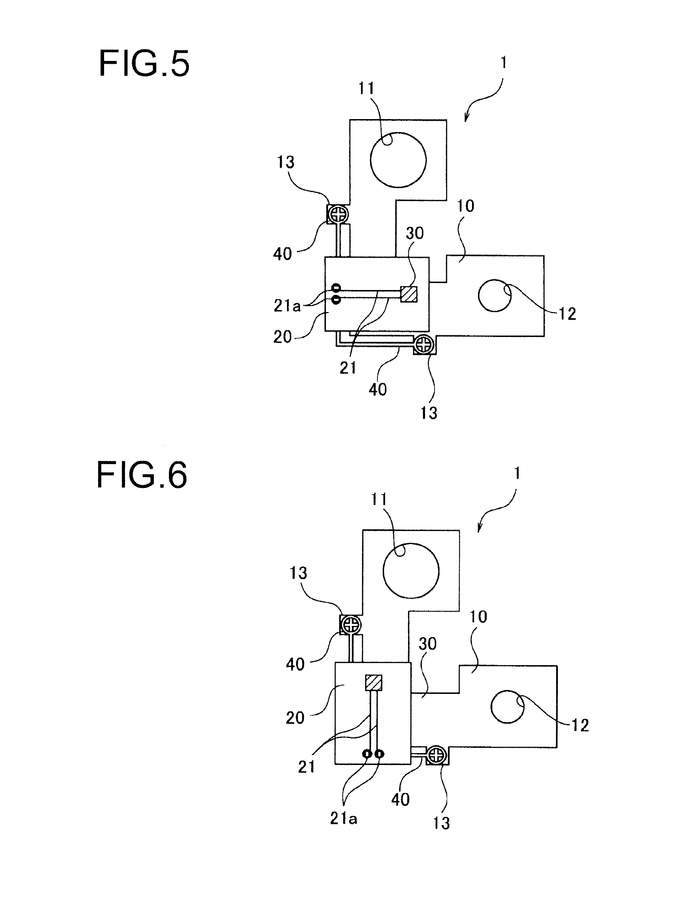

The aforesaid embodiment employs the layout that, on the circuit board 20, the voltage detection lands 21a and the voltage detection IC 30 are connected to the circuit patterns 21 each configured so as to extend in the L-shape. Alternatively, as shown in Fig. 5, the embodiment may employ a layout that the voltage detection lands 21 a and the voltage detection IC 30 are connected to the circuit patterns 21 each configured so as to extend laterally (left and right direction in Fig. 5) in a straight shape. Further, alternatively, as shown in Fig. 6, the embodiment may employ a layout that the voltage detection lands 21 a and the voltage detection IC 30 are connected to the circuit patterns 21 each configured so as to extend longitudinally (perpendicular direction in Fig. 6) in a straight shape.

Even in such the configuration, effects similar to that of the aforesaid shunt resistance type current sensor 1 can be attained.

Although the explanation is made as to the shunt resistance type current sensors according to the embodiments, the invention is not limited to the aforesaid embodiments and may be modified in various manners within the range of the invention. For example, although a part of the bus bar is configured to be contained in the shunt resistor, the invention is not limited thereto and the entirety of the bus bar may be utilized as the shunt resistor.

The feature of the embodiments of the connector according to the invention will be briefly summarized below as listed in [1] to [5].

[1] A shunt resistance type current sensor, including:
   a bus bar (10) having a plate shape;
   a circuit board (20) that is disposed above the bus bar;
   a pair of connection terminals (40) that electrically connect between the circuit board and the bus bar; and
   a voltage detector (the voltage detection IC 30) which is mounted on the circuit board, and detects the value of voltage applied to the circuit board via the pair of connection terminals in order to detect the value of current to be measured flowing through the bus bar,
   wherein the circuit board includes the pair of circuit patterns (21) and the pair of voltage detection lands (21a) for electrically connecting between the pair of circuit patterns and the connection terminals, one end of each of the circuit patterns being connected to the voltage detector and the other end of the each of the circuit patterns being connected at its the other end to corresponding one of the voltage detection lands; and
   wherein the pair of voltage detection lands and the voltage detector are disposed separately to each other to a degree that thermal influence on the pair of voltage detection lands due to heat generated by the voltage detector can be suppressed.
[2] The shunt resistance type current sensor described in [1], wherein the pair of voltage detection lands are respectively disposed at positions close to each other to a degree that temperatures of the lands are regarded to be substantially same value, on the circuit board which temperature distribution becomes non-uniform due to the heat generated by the voltage detector.
[3] The shunt resistance type current sensor described in [2], wherein the distance between the pair of voltage detection lands is shorter than the distance between the pair of voltage detection lands and the voltage detector.
[4] The shunt resistance type current sensor described in one of [1] to [3], wherein each of the pair of connection terminals is configured by the narrow plate member which thickness.is smaller than the thickness of the bus bar; and

Wherein the connection terminals, that extend on the plane where the bus bar is formed, are raised toward the circuit board and penetrate the circuit board at the positions where the voltage detection lands are provided, respectively.
[5] The shunt resistance type current sensor described in [4], wherein each of the pair of connection terminals is composed of the same material as the bus bar.

Although the invention is explained in detail and with reference to the embodiments, it will be obvious for those skilled in the art that various changes and modifications may be made without departing from the spirit and range of the invention.

The present application is based on Japanese Patent Application filed on September 21, 2012 (Japanese Patent Application No. 2012-208093), which contents is incorporated herein by reference.

### Industrial Applicability

According to the shunt resistance type current sensor of the invention, the thermal electromotive force generated between the circuit pattern on the circuit board and the bus bar can be suppressed. Thus, the voltage drop generated across the shunt resistor can be detected accurately. The invention attaining such the effect is useful in the field of the shunt resistance type current sensors.

### Reference Signs List

- 1: shunt resistance type current sensor
- 10: bus bar
- 11: through hole
- 12: through hole
- 13: bus bar voltage detection part
- 20: circuit board
- 21: circuit pattern
- 21a: voltage detection land
- 30: voltage detection IC
- 40: connection terminal
- 70: battery
- 71: battery post
- 72: fixing screw
- W: wire harness

## Claims

1. A shunt resistance type current sensor, comprising:
a bus bar having a plate shape;
a circuit board that is disposed above the bus bar;
a pair of connection terminals that electrically connect between the circuit board and the bus bar; and
a voltage detector that is mounted on the circuit board, and detects a value of voltage applied to the circuit board via the pair of connection terminals in order to detect a value of current to be measured flowing through the bus bar,
wherein the circuit board includes a pair of circuit patterns and a pair of voltage detection lands for electrically connecting between the pair of circuit patterns and the connection terminals, one end of each of the circuit patterns being connected to the voltage detector and the other end of the each of the circuit patterns being connected to corresponding one of the voltage detection lands; and
wherein the pair of voltage detection lands and the voltage detector are disposed separately to each other to a degree that thermal influence on the pair of voltage detection lands due to heat generated by the voltage detector can be suppressed.

2. The shunt resistance type current sensor according to claim 1, wherein the pair of voltage detection lands are respectively disposed at positions close to each other to a degree that temperatures of the lands are regarded to be substantially same value, on the circuit board which temperature distribution becomes non-uniform due to the heat generated by the voltage detector.

3. The shunt resistance type current sensor according to claim 2, wherein a distance between the pair of voltage detection lands is shorter than a distance between the pair of voltage detection lands and the voltage detector.

4. The shunt resistance type current sensor according to any one of claims 1 to 3, wherein each of the pair of connection terminals is configured by a narrow plate member which thickness is smaller than a thickness of the bus bar; and
wherein the connection terminals, that extend on a plane where the bus bar is formed, are raised toward the circuit board and penetrate the circuit board at positions where the voltage detection lands are provided, respectively.

5. The shunt resistance type current sensor according to claim 4, wherein each of the pair of connection terminals is composed of same material as the bus bar.
